# FASCICULE DE BREVET EUROPEEN

(11) **EP 0 455 681 B1**
(45) Date de publication et mention de la délivrance du brevet: **18.08.1993**
(21) Numéro de dépôt: 90902286.5
(22) Date de dépôt: 22.01.1990
(51) Int. Cl.: C01G 29/00, C04B 35/00

(54) **OXYDE DE CUIVRE A VALENCE MIXTE CONTENANT DU PLOMB ET DU BISMUTH ET SON PROCEDE DE FABRICATION**
KUPFEROXID MIT GEMISCHTER WERTIGKEIT, ENTHALTEND BLEI UND WISMUTH, UND VERFAHREN ZU SEINER HERSTELLUNG
MIXED-VALENCY COOPER OXIDE CONTAINING LEAD AND BISMUTH AND PROCESS FOR ITS PRODUCTION

(30) Priorité: 24.01.1989 FR 8900802
(43) Date de publication de la demande: 13.11.1991
(73) Titulaire: CENTRE NATIONAL DE LA RECHERCHE SCIENTIFIQUE (CNRS), 75700 Paris Cedex 07 (FR)
(72) Inventeur: RETOUX, Richard, F-61000 Alençon (FR); HERVIEU, Maryvonne, F-14970 Benouville (FR); RAVEAU, Bernard, F-14112 Beuville (FR); MICHEL, Claude, F-14200 Hérouville-S.-Clair (FR)
(74) Mandataire: Martin, Jean-Jacques
(86) Numéro de dépôt international: FR9000048
(87) Numéro de publication internationale: WO9008740

(56) Documents cités:
- FR-A-25 693 98
- Journal of the Less-Common Metals, vol. 144, 1988, Elsevier Sequoia, (Lausanne, CH) S.Kemmler Sack et al.:"Neuer Hoch-Tc-Supraleiter im System Bi -Pb-Sr-Ca-Cu-O", pages L1-L3
- Physica C, vol. 159, no.3, 15 June 1989, Elvesier Science Publishers B.V., (North Holland Physics Publishing Division), (Amsterdam, NL), K.Kadowaki et al.: "Synthesis, phase formation and high-Tc superconductivity at 78 K of Pb2 Sr2Y1-xCaxCu3O8+8", pages 165-172
- La Recherche, vol. 19, no. 195, Janv.1988, p.53-60

## Description

La présente invention a pour objet de nouveaux oxydes de cuivre à valence mixte de structure dérivée de la pérowskite.

Elle a plus particulièrement pour objet des compositions supraconductrices présentant au moins partiellement une structure dérivée de la pérowskite.

Au cours du dernier lustre, ces oxydes, qui résultent d'une intercroissance d'une structure de type pérowskite et d'une structure de type chlorure de sodium, on fait l'objet de très nombreuses études, et ce d'autant plus que leurs propriétés électriques et plus particulièrement supraconductrices ont été démontrées à des températures supérieures à 60/70 K.

Ces oxydes de cuivre présentent des structures en général qualifiées de déficitaires en oxygène, ce qui signifie qu'il n'y a pas assez d'oxygène pour remplir tous les sites disponibles de la pérowskite. En fait, ils présentent des zones surstoechiométriques en oxygène par rapport. au cuivre au degré d'oxydation +2. Cette surstoechiométrie est sans doute reliée à leur caractéristique d'être supraconducteurs à des températures relativement élevées.

Les structures de ces composés d'oxyde de cuivre sont décrites dans de nombreuses publications. Parmi ces dernières, il convient de citer :
A) Article de B. RAVEAU "De nombreuses structures d'oxydes peuvent être construites à partir du type de base Re0₃" - Proc. Indian Natn. Sci Acad., 52, A, n° 1, 1986, pages 67-101 ;
B) Article de L. ER-RAKHO, C. MICHEL, J. PROVOST et B. RAVEAU "Séries de pérowskites à défaut d'oxygène contenant CuII, CuIII" - Journal of Solid State Chemistry 37, 151-156 (1981) ;
C) Article de C. MICHEL et B. RAVEAU "Intercalation d'oxygène dans les oxydes de cuivre à valence mixte apparentés aux perovskites" - Revue de Chimie Minérale, t 29, 1984, page 407 ;
D) Article de C. MICHEL, F. DESLANDES, J. PROVOST, P. LEGAY, R. TOURNIER, M. HERVIEU, B. RAVEAU, C.R.Académie des Sciences, Tome 304, II, N° 17, p.1059 (1987) ;
E) Article de C. MICHEL, F. DESLANDES, J. PROVOST, P. LEJAY, R. TOURNIER, M. HERVIEU et B. RAVEAU, compte rendu à l'Académie des Sciences, t 304, II, n° 19, p.1169 ( 1987).
F) L'article de synthèse, qui outre les propriétés structurales décrit des propriétés électriques et magnétiques et qui est publié dans la Recherche n° 195 en Janvier 1988, vol. 19, pages 53-60, intitulé "La découverte de la supraconductivité à haute température" par K. Alex MÜLLER et J. Georg BEDNORZ.

Par ailleurs, de telles structures et leurs applications industrielles ont été, par exemple, décrites dans les demandes de brevet dont les objets sont des inventions réalisées au Laboratoire CRISMAT de Caen, rattaché au C.N.R.S., notamment celles sous les numéros 87 03717 et 87 03975.

Au cours de l'année écoulée, de nombreuses sous-familles d'oxyde de cuivre à valence mixte à structure dérivée de la pérowskite ont été étudiées et ce notamment dans la perspective d'obtenir une palette de supraconducteurs ayant des caractéristiques particulières et mieux adaptées que d'autres à certaines applications.

Le nombre d'éléments utilisés dans ces structures et la variabilité des proportions conduisent à un nombre de combinaisons quasi infini. Seule une fraction très réduite de ces composés possède des propriétés électriques intéressantes.

Plus particulièrement, on a recherché à obtenir des pérowskites dont le point de résistance nulle (Tc^{R=0}) soit supérieur à la température d'ébullition de l'azote liquide. Un progrès considérable a été réalisé lorsque des oxydes de cuivre à valence mixte comportant du thallium ont été découverts, leurs Tc^{R=0} étant parfois supérieures à 100K.

Toutefois, ces composés présentent un inconvénient majeur, à savoir la toxicité et la volatilité du thallium. Enfin, pour certaines applications, une croissance rapide de la résistivité en fonction de la température peut être désirée au delà de la température critique.

Une famille présentant une forte pente de la résistivité en fonction de la température a déjà été décrite dans l'article paru dans la revue Nature, Volume 336, p. 211-214, 1988, sous le titre "Superconductivity Near 70K in a New Family of Layered Copper Oxides" par R.J. Cava et al. Cette famille de formule générale Pb₂Sr₂ACu₃O_{8+δ} où A représente une terre rare ou une terre rare plus du strontium ou du calcium. Toutefois, ces compositions présentent une faible température critique de résistance nulle ; pour leur meilleur représentant, elle est égale à 46K.

C'est pourquoi un des buts de la présente invention est de fournir une nouvelle composition ayant une forte pente de croissance de la résistivité en fonction de la température, tout en ayant une température critique à résistance nulle supérieure ou égale à environ 40°K.

Ces buts et d'autres qui apparaîtront par la suite, sont atteints au moyen d'un oxyde de cuivre à valence mixte, dérivé de la structure de la pérowskite et de formule :

Pb_{2+x₁} Bi_{x₂} Sr_{2 + x₃} Tr_{1-y}Ca_{y}Cu₃O_{8 + δ} (I)

avec x₁ + x₂ + x₃ = 0,
x₁ étant compris dans l'intervalle [-1,+1]
x₂ étant compris dans l'intervalle ]0,1], de préférence au moins égal à environ 0,1,
et x₃ étant compris dans l'intervalle [-1,+1] ;
y est compris dans l'intervalle ]0,1], de préférence supérieur à 0,1 ;
Tr est une élément choisi dans le groupe des terres rares (lanthanides, lanthane, yttrium, scandium) ;
δ = est compris dans l'intervalle [0, +1/4].

Avantageusement, x₁ est négatif ce qui correspond à une substitution du plomb, soit par du bismuth, soit par du strontium et du bismuth ; x₂ est avantageusement compris dans l'intervalle [0,1, 2/3], de préférence, entre 1/3 et 2/3, plus précisément entre 0,4 et 0,6 ; x₃ est avantageusement compris entre - 0,5 et + 0,5. La valeur de y quant à elle est avantageusement comprise entre 0,3 et 1, de préférence supérieure ou égale à 0,4.

Une sous-famille plus spécifiquement étudiée, est celle où x₃ est voisin de ou égal à 0, c'est-à-dire que x₃ est égal à 0 aux indéterminations près qui peuvent être durs aux manipulations et/ou dues aux hétérogéneités cristallines. Dans ces conditions, x₁ = - x et x₂ = x et la formule de l'oxyde de cuivre à valence mixte devient :

Pb₂₋ₓBiₓSr₂Tr_{1-y}Ca_{y}Cu₃O_{8+ δ} (II)

où x est supérieur à 0 et au plus égal à 2/3,
y est compris dans l'intervalle demi-fermé ]0,1],
Tr est choisi dans le groupe constitué par les terres rares, à l'exception des terres rares ayant une valence IV.

Dans ces conditions, les valeurs préférées de x correspondent aux valeurs préférées de x₂ spécifiée ci-dessus, les valeurs préférées de y restant inchangées. Avantageusement, on choisit Tr dans le groupe constitué par l'yttrium et les terres yttriques, c'est-à-dire le groupe constitué par l'yttrium et la fraction des lanthanides allant du gadolinium au lutétium ; plus spécifiquement encore Tr représente l'yttrium.

Ainsi que cela a été explicité dans les exemples cette nouvelle sous-famille permet d'obtenir des valeurs de température critique correspondant au point de résistance nulle, relativement élevée, pouvant atteindre jusqu'à 79 et 77K, soit des valeurs qui sont au voisinage ou supérieures de la température d'ébullition de l'azote liquide.

Les meilleurs résultats ont été obtenus avec x = 0,6, y = 1 avec une température critique R = 0 de 77K et x = 0,6, y = 0,5 avec une température critique R = 0 de 79 K.

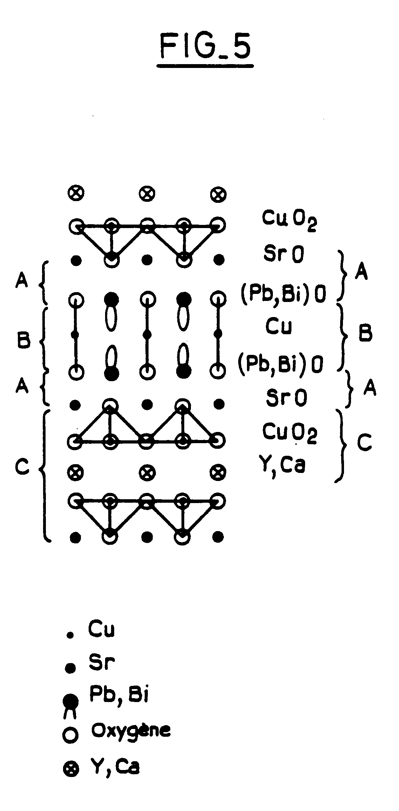

La figure 5 montre la structure idéale limite (c'est-à-dire que les défauts de structure n'y figurent pas) des composés selon l'invention. Dans cette figure, la terre rare est l'yttrium et on a choisi x₃ = 0. On remarque la séquence suivante :
a) Une monocouche de type NaCl référencée A, de formule (Sr_{0,5}Pb_{0,5-x/4}Bi_{x/4})O isolante.
b) Une monocouche de type pérowskite référencée B, cette couche est très déficitaire en oxygène et ne contient le cuivre qu'à l'état d'oxydation (I) ; elle est de formule Pb_{1-x/2} Bi_{x/2} CuO ; cette couche est isolante s'il y a excès d'oxygène par rapport à 8, l'oxygène en supplément viendra se mettre dans le plan des cuivres pour donner la formule : Pb_{1-x/2} Bi_{x/2} CuO _{1 + δ .}
c) Une couche de type NaCl référencée A, de formule (Sr_{0,5}Pb_{0,5-x/4}Bi_{x/4})O qui est isolante ;
d) Une double couche de type pérowskite déficitaire en oxygène référencée C ; cette couche est conductrice et est de formule : SrY_{1-y}Ca_{y}Cu₂O₅.

Un autre but de la présente invention est de fournir un procédé de synthèse des oxydes de cuivre à valence mixte selon l'invention, ce but est atteint au moyen du procédé de synthèse des oxydes de cuivre à valence mixte comportant les étapes suivantes :
a) broyage et mélange d'oxyde de bismuth, de monoxyde de plomb, de Sr₂CuO₃, de CuO, de Tr₂O₃ et de CaO en proportion désirée,
b) compression des mélanges obtenus en a) sous forme de pastilles,
c) soumission de ces pastilles à un chauffage à une température comprise entre 700 et 900°C, de préférence entre 750 et 850°C, sous atmosphère inerte contenant une faible proportion d'oxygène pendant 1/2 à 2 journées,
d) refroidissement rapide à température ambiante.

Par refroidissement rapide il faut comprendre un refroidissement entre 10 minutes et 1/2 heure (1/4 d'heure environ).

Le broyage est réalisé de manière à obtenir une granulométrie usuelle en la matière, telle qu'une granulométrie présentant un d₈₀ inférieur à 20 micromètres, de préférence à 10 micromètres, en général autours de 5 micromètres. Il est possible de travailler à des mailles de broyage encore plus faibles en réalisant un broyage humide, ce qui est relativement favorable au composé final mais qui nécessite une opération de séchage avant l'étape b) ou au cours de l'étape a). C'est pourquoi un broyage à sec est préféré. La compression de l'étape b) est réalisée sous pression usuelle en la matière, telle que des compressions supérieures à 0,5 tonne/cm² (50.10⁶ Pa) en général entre 0,1 et 1.10⁹Pa.

Par faible proportion d'oxygène, il convient de comprendre une proportion suffisante pour que l'oxyde soit supraconducteur et insuffisante pour que le plomb passe à l'état d'oxydation IV. Il est par ailleurs avantageux que la teneur en oxygène soit telle que la partie du cuivre structurellement à valence I reste à cette dernière valence. En effet, dans la structure selon l'invention, sur trois atomes de cuivre, deux sont à des état de valence mixte, cependant que le dernier est à la valence I.

A titre indicatif, la teneur en oxygène doit être inférieure à 10 %, en général comprise entre 0,5 et 5 %, de préférence aux alentours de 1 %.

Par atmosphère inerte, il convient de comprendre de l'azote, des gaz rares, leurs mélanges ou tout mélange de gaz restant inerte par rapport aux oxydes de cuivre à valence mixte et aux produits de départ décrits ci-dessus.

Il est également possible de réaliser cette synthèse à des pressions non atmosphériques. Dans ces cas là, les conditions sur la teneur en oxygène restent identiques, exprimées en pression partielle d'oxygène.

Dans ce procédé, les oxydes peuvent être remplacés par tout corps qui par décomposition thermique donne l'oxyde désiré. On peut ainsi utiliser des carbonates en lieu et place d'oxyde.

Les exemples non limitatifs suivants montrent les caractéristiques des nouveaux supraconducteurs selon la présente invention.

### Exemples 1 à 4

Divers mélanges correspondants à la formule II ont été préparés à partir de Bi₂O₃, PbO, Sr₂CuO₃, CuO, Tr₂O₃, CaO. Ces mélanges sont mis sous forme de pastilles par compression sous une pression de l'ordre de 1 à 10 tonnes/cm² (de 0,1 à 1.10⁹Pa). Les pastilles ainsi obtenues sont portées entre 750 et 850°C sous atmosphère d'azote pendant environ 15 heures, puis sont refroidies à la température ambiante en 15 minutes.

Les pastilles sont broyées à une granulométrie comprise entre environ 10 et environ 20 micromètres.

Les échantillons servant aux caractérisations physiques sont préparés sous forme de barreaux de 12 x 2 x 0,5 mm³, les poudres de granulométrie comprise entre 10 et 20 micromètres, sont pressées sous 4 tonnes/cm² (0,4.10⁹Pa) et frittées pendant 4 à 5 heures sous la même atmosphère que celle utilisée pour la synthèse, et à la même température.

### Transition résistive

La méthode utilisée est celle des quatre points : 1 contact à chaque extrémité du barreau, 2 contacts sur une des faces. Les contacts sont faits soit par laque argent, soit par diffusion d'indium dans le fritté au moyen des ultra-sons.

Un générateur de courant (modèle 103A - Adret Electronique) envoie dans l'échantillon, par les pointes externes, un courant continu (5.10⁻³ mA ≦ 1 ≦ 109,99 mA). La tension entre les pointes centrales est mesurée à l'aide d'un multimètre numérique Keithley de résolution 1 µV.

### Mesures magnétiques

On utilise un magnétomètre à échantillon vibrant type Foner (modèle 155 de chez EGG) équipé d'un cryostat et permettant de travailler jusqu'à 4,2K. L'échantillon est un barreau fritté de quelques millimètres de longueur. Il est fixé au bout d'une tige rigide dont l'autre extrémité est fixée au vibreur.

Le déplacement de l'échantillon, placé dans un champ magnétique uniforme, devant les bobines captrices, donne naissance à une tension induite à la fréquence de déplacement.

On peut ainsi déterminer le moment magnétique de l'échantillon, en fonction du champ magnétique uniforme appliqué et de la température.

Le volume supraconducteur est mesuré à 4,2K en comparant la susceptibilité diamagnétique observée à celle que l'on devrait obtenir pour un échantillon totalement diamagnétique (niobium comme référence) et en tenant compte de la forme de l'échantillon.

### Exemple 1

On a pu ainsi isoler des phases non-supraconductrices lorsque y était égal à 0 quelle que soit la valeur de x et supraconductrices dans le reste du domaine. Ainsi, il a été vérifié que pour y = 1, c'est-à-dire où la totalité d'yttrium a été remplacée par le calcium, il y a une bonne supraconductivité avec x compris dans l'intervalle 0,1-0,6 ;

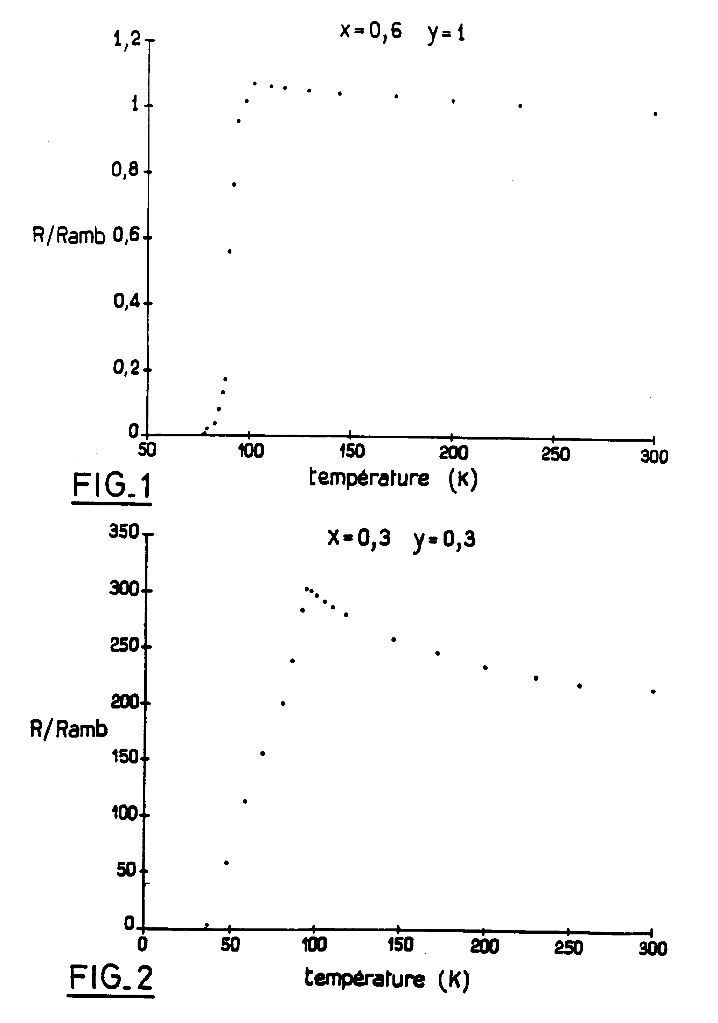

Plus spécifiquement, les compositions pour x = 0,6 y = 1 montrent une température critique Tc^{R=0} de 77K et une courbe R/Ramb (R étant la résistance à la température K et Ramb = résistance à la température ambiante) en fonction de la température exprimée en K, telle que relevée à la figure 1 (R/Ramb = f(K).

Une étude de diamagnétisme montre que 6 % du volume est supraconducteur.

### Exemple 2

Le mode opératoire et les mesures étant réalisés selon le même protocole que pour l'exemple 1, on réalise le composé correspondant à x = 0,3 y = 0,3 . Ce composé présente une température critique de Tc^{R=0} = 39K avec 15 % de volume supraconducteur. La courbe R/Ramb en fonction de la température est montrée à la figure 2.

### Exemple 3

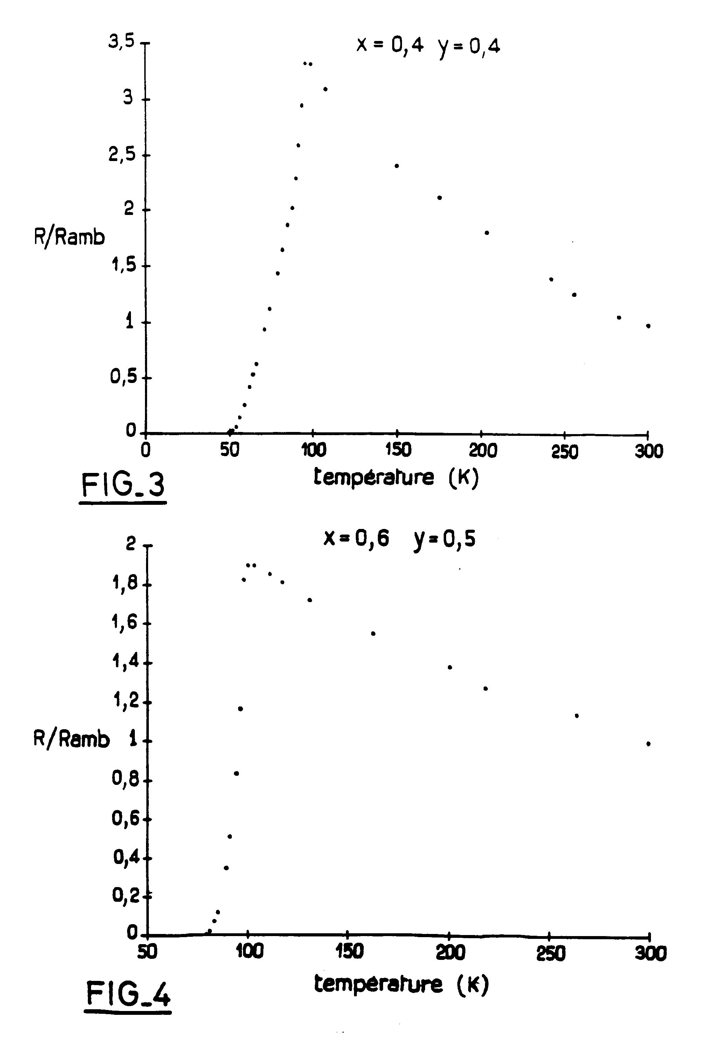

Le mode opératoire et les mesures étant réalisés selon le même protocole que pour l'exemple 1, on réalise le composé correspondant à x = 0,4 ; y = 0,4. Ce composé présente une température critique Tc^{R=0} = 50 K avec 13 % du volume supraconducteur. La figure 3 montre la courbe résistance/résistance à température ambiante en fonction de la température exprimée en Kelvin.

### Exemple 4

Le mode opératoire et les mesures étant réalisés selon le même protocole que pour l'exemple 1, on réalise le composé correspondant à x = 0,6 y = 0,5. Ce composé présente une température critique Tc^{R=0} est de 79 K avec 25 % de volume supraconducteur. La figure 4 montre comment évolue le rapport résistance/résistante. à température ambiante en fonction de la température exprimée en Kelvin.

## Revendications

1. Oxyde de cuivre à valence mixte, dérivé de la structure de la pérowskite et de formule :
Pb_{2+x₁} Bi_{x₂} Sr_{2 + x₃} Tr_{1-y}Ca_{y}Cu₃O_{8 + δ} (I)
avec x₁ + x₂ + x₃ = 0,
x₁ étant compris dans l'intervalle [-1,+1]
x₂ étant compris dans l'intervalle ]0,1] de préférence au moins égal à environ 0,1,
et x₃ étant compris dans l'intervalle [-1,+1]
y est compris dans l'intervalle ]0,1], de préférence supérieur à 0,1 ;
Tr est un élément choisi dans le groupe des terres rares (lanthanides, lanthane, yttrium, scandium) ;
δ = est compris dans l'intervalle [0,+1/4].

2. Oxyde de cuivre selon la revendication 1, caractérisé par le fait que x₂ est compris dans l'intervalle [0,1, 2/3].

3. Oxyde de cuivre selon les revendications 1 et 2 prises séparément, caractérisé par le fait que x₁ est négatif.

4. Oxyde de cuivre selon les revendications 1 à 3 prises séparément, caractérisé par le fait qu'il répond à la formule suivante :
Pb₂₋ₓBiₓSr₂Tr_{1-y}Ca_{y}Cu₃O_{8+ δ} (II) où
x est compris dans l'intervalle ]0,2/3]
y est compris dans l'intervalle ]0,1],
Tr est choisi dans le groupe constitué par les terres rares, à l'exception des terres rares ayant une valence IV.

5. Oxyde de cuivre selon la revendication 4, caractérisé par le fait que x est choisi dans l'intervalle [0,1,2/3], de préférence dans l'intervalle [1/3,2/3].

6. Oxyde de cuivre selon les revendications 4 à 5 prises séparément, caractérisé par le fait que y est compris dans l'intervalle [0,3-1], de préférence [0,4-1].

7. Oxyde de cuivre selon les revendications 1 à 6 prises séparément, caractérisé par le fait que Tr est choisi dans le groupe constitué par l'yttrium et les terres yttriques.

8. Oxyde de cuivre selon la revendication 7, caractérisé par le fait que Tr est l'yttrium.

9. Procédé de synthèse des oxydes de cuivre à valence mixte selon les revendications 1 à 8, caractérisé par le fait qu'il comporte les étapes suivantes :
a) broyage et mélange d'oxyde de bismuth, de monoxyde de plomb, de Sr₂CuO₃, de CuO, de Tr₂O₃ et de CaO en proportion désirée,
b) compression des mélanges obtenus en a) sous forme de pastilles,
c) soumission de ces pastilles à un chauffage à une température comprise entre 700 et 900°C, de préférence entre 750 et 850°C, sous atmosphère inerte contenant une faible proportion d'oxygène d'au plus 10 % pendant 1/2 à 2 journées,
d) refroidissement rapide à température ambiante.

## Patentansprüche

1. Oxid von Kupfer mit gemischter Valenz, das von der Perwoskit-Struktur abgeleitet ist und die Formel hat
Pb₂_{+x₁} Bi_{x₂} Sr₂_{+ x₃}Tr₁_{-y}Ca_{y}Cu₃O_{8 + δ} (I)
mit x₁ + x₂ + x₃ = 0, wobei
x₁ in dem Intervall [-1, +1] liegt,
x₂ in dem Intervall ]0, 1] liegt, vorzugsweise mindestens gleich etwa 0,1 ist und
x₃ in dem Intervall [-1, +1] liegt;
y in dem Intervall ]0,1] liegt, vorzugsweise oberhalb 0,1 liegt;
Tr ein Element, ausgewählt aus der Gruppe der Seltenen Erden (der Lanthaniden, Lanthan, Yttrium, Scandium), darstellt;
δ in dem Intervall [0, +1/4] liegt.

2. Kupferoxid nach Anspruch 1, dadurch gekennzeichnet, daß x₂ in dem Intervall [0,1, 2/3] liegt.

3. Kupferoxid nach den getrennt genommenen Ansprüchen 1 und 2, dadurch gekennzeichnet, daß x₁ negativ ist.

4. Kupferoxid nach den getrennt genommenen Ansprüchen 1 bis 3, dadurch gekennzeichnet, daß es die folgende Formel hat
Pb₂₋ₓBiₓSr₂Tr_{1-y}Ca_{y}Cu₃O_{8 + δ} (II)
worin:
x in dem Intervall ]0, 2/3] liegt,
y in dem Intervall ]0,1] liegt,
Tr ausgewählt wird aus der Gruppe, die besteht aus den Seltenen Erden mit Ausnahme der Seltenen Erden mit einer Valenz von VI.

5. Kupferoxid nach Anspruch 4, dadurch gekennzeichnet, daß x ausgewählt wird aus dem Intervall [0,1, 2/3], vorzugsweise aus dem Intervall [1/3, 2/3].

6. Kupferoxid nach den getrennt genommenen Ansprüchen 4 bis 5, dadurch gekennzeichnet, daß y in dem Intervall [0,3-1], vorzugsweise in dem Intervall [0,4-1], liegt.

7. Kupferoxid nach den getrennt genommenen Ansprüchen 1 bis 6, dadurch gekennzeichnet, daß Tr ausgewählt wird aus der Gruppe, die besteht aus Yttrium und den Yttererden.

8. Kupferoxid nach Anspruch 7, dadurch gekennzeichnet, daß Tr für Yttrium steht.

9. Verfahren zur Synthese von Kupferoxiden mit gemischter Valenz nach den Ansprüchen 1 bis 8, dadurch gekennzeichnet, daß es die folgenden Stufen umfaßt:
a) Zerkleinern (Mahlen) und Mischen von Wismutoxid, Bleimonoxid, Sr₂CuO₃, CuO, Tr₂O₃ und CaO in dem gewünschten Mengenverhältnis,
b) Pressen der in der Stufe (a) erhaltenen Gemische unter Bildung von Tabletten (Pellets),
c) Erwärmen dieser Tabletten (Pellets) auf eine Temperatur zwischen 700 und 900°C, vorzugsweise zwischen 750 und 850°C, in einer inerten Atmosphäre, die einen geringen Sauerstoffanteil von höchstens 10 % enthält, für 1/2 bis 2 Tage, und
d) schnelles Abkühlen auf Umgebungstemperatur.

## Claims

1. Mixed-valency copper oxide, derived from the perowskite structure and of the formula:
Pb₂₊ₓ₁ Biₓ₂ Sr₂₊ₓ₃ Tr_{1-y}Ca_{y}Cu₃O_{8+ δ} (I)
with x₁+x₂+x₃=0,
x₁ being comprised within the range [-1, +1]
x₂ being comprised within the range ]0,1] preferably at least equal to about 0.1,
and x₃ being comprised within the range [-1,+1]
y is comprised in the range ]0.1], preferably higher than 0,1; Tr is an element selected from the group of rare earths (lanthanides, lanthanum, yttrium, scandium);
δ = is comprised in the range [0, +1/4].

2. Copper oxide according to claim 1, characterised by the fact that x₂ is comprised in the range [0,1, 2/3].

3. Copper oxide according to claims 1 and 2, separately, characterised by the fact that x₁ is negative.

4. Copper oxide according to claims 1 to 3 taken separately, characterised by the fact that it corresponds to the following formula:
Pb₂₋ₓBiₓSr₂Tr_{1-y}Ca_{y}Cu₃O₈+ δ (II) where
x is comprised in the range ]0, 2/3]
y is comprised in the range ]0, 1],
Tr is selected in the group constituted by the rare earths, with the exception of the rare earths having a valency IV.

5. Copper oxide according to claim 4, characterised by the fact that x is selected in the range [0, 1, 2/3], preferably in the range [1/3, 2/3].

6. Copper oxide according to claims 4 to 5, taken separately, characretised by the fact that y is comprised in the range [0, 3-1], preferably [0, 4-1].

7. Copper oxide according to claims 4 to 5, taken separately, characterised by the fact that Tr is selected by the group constituted by yttrium and yttrium earths.

8. Copper oxide according to claim 7. characterised by the fact that Tr is yttrium.

9. Process for the synthesis of copper oxides with mixed-valency according to claims 1 to 8, characterised by the fact that it comprises the following steps:
a) grinding and mixing of bismuth oxide, of lead monoxide, of Sr₂CuO₃, of CuO, of Tr₂O₃ and of CaO in the desired proportion,
b) compression of the mixes obtained a) in the form of pastilles,
c) subjection of these pastilles to heating to a temperature comprised between 700 and 900°C, preferably between 750 and 850°C, under an inert atmosphere containing a low proportion of oxygen of at the most 10% for 1/2 to 2 days,
d) rapid cooling to room temperature.
